Europäisches Patentamt

European Patent Office

Office européen des brevets

(19)

(11) Veröffentlichungsnummer: **0 364 672**

**A2**

(12)

# EUROPÄISCHE PATENTANMELDUNG

(21) Anmeldenummer: **89112412.5**

(22) Anmeldetag: **07.07.89**

(51) Int. Cl.⁵: **G02B 6/42 , H01S 3/043**

(30) Priorität: **20.10.88 DE 3835701**

(43) Veröffentlichungstag der Anmeldung:
**25.04.90 Patentblatt 90/17**

(84) Benannte Vertragsstaaten:
**ES FR GB IT NL SE**

(71) Anmelder: **Messerschmitt-Bölkow-Blohm Gesellschaft mit beschränkter Haftung Robert-Koch-Strasse D-8012 Ottobrunn(DE)**

(72) Erfinder: **Tilly, Bodo Lena-Christ-Strasse 25 D-8018 Grafing(DE)**
Erfinder: **Rieger, Robert Weichingerstrasse 2 D-8201 Ostermünchen(DE)**

(54) **Anordnung für eine Laserdiode mit integrierter Ansteuerelektronik.**

(57) Die Erfindung bezieht sich auf eine Anordnung für eine Laserdiode mit angeschlossener Ansteuerelektronik, die in Form eines Chips mit einer Wärmesenke vor einer ortsfesten Lichtleitfaser innerhalb eines u-förmigen Kühlkörperprofils positioniert ist und durch mechanischen Druck einer Blattfeder derart gehalten wird, daß sie eine reproduzierbare Justierung mittels X-Y-Verschiebegreifzangen erlaubt und anschließend durch Laser-Punktschweißen oder Laserlöten fixiert wird. Ein Ausführungsbeispiel ist beschrieben und in den Figuren der Zeichnung skizziert.

FIG. 1

EP 0 364 672 A2

## Anordnung für eine Laserdiode mit integrierter Ansteuerelektronik

Die Erfindung bezieht sich auf eine Anordnung für eine Laserdiode mit angeschlossener Ansteuerelektronik, die in Form eines Chips mit einer Wärmesenke vor einer ortsfesten Lichtleitfaser positioniert ist.

Solche Laserdiodenchips sind allgemein bekannt und auch im Handel erhältlich. Deren Wärmesenke muß jedoch bisher mit einem Kühlkörper zusätzlich verschraubt werden, dann wird diese Anordnung mit ihrer integrierten Elektronikschaltung in ein Gehäuse eingesetzt, durch dessen Wand das Glasfaserkabel hindurchzuführen ist, dessen Lichtleitfaser anschließend genau zur Diode des Chips auszurichten und zu fixieren ist. Hierbei muß die Justage der fadendünnen Lichtleitfaser in den drei Freiheitsgraden X,Y und Z erfolgen. Das relativ lange, nur einseitig gehaltene und sonst freischwebende Faserende muß zur Beseitigung von Schwingungen aufgrund von Vibrationen, Erwärmungen usw. unmittelbar nach der Feinjustierung vor der Diode ebenfalls eingespannt werden, was nicht nur sehr problematisch und aufwendig ist und zu einer relativ hohen Ausschußquote bei der seriellen Fertigung führt, sondern stets die Gefahr gegeben ist, daß die beidseitig eingespannte Faser bei hohen Wärmeausdehnungen reißt. Ein weiteres Problem ist durch die Tatsache gegeben, daß nach Fertigjustage der Glasfaser, die Kabeldurchführung im Gehäuse und dieses selbst zuverlässig vakuumdicht durch Laserschweißung zu verschließen ist und Maßnahmen zu treffen sind, daß durch diese Verschweißung die bereits durchgeführte Justierung des Lichtleiters nicht beeinträchtigt wird.

Der vorliegenden Erfindung liegt die Aufgabe zugrunde, eine Anordnung der eingangs genannten Art zu schaffen, die den Justageaufwand vermindert, die Lichtleitfaser nicht überbestimmt und eine zuverlässige, starre, einwandfrei justierte Aufnahme des Laserchips gegenüber der Glasfaser gewährleistet.

Diese Aufgabe wird durch die im Anspruch 1 aufgezeigten Maßnahmen gelöst. In den Unteransprüchen sind Ausgestaltungen und Weiterbildungen angegeben und in der nachfolgenden Beschreibung ist ein Ausführungsbeispiel erläutert und in den Figuren der Zeichnung skizziert. Es zeigen:

Fig. 1 eine perspektivische Ansichtsskizze eines Ausführungsbeispiels in einem Teilausschnitt,

Fig. 2 eine Seitenansicht eines Ausführungsbeispiels des aus Trägerelement und Kühlkörper kombinierten Bauteils,

Fig. 2a eine Draufsicht auf das Ausführungsbeispiel gemäß Fig. 2.

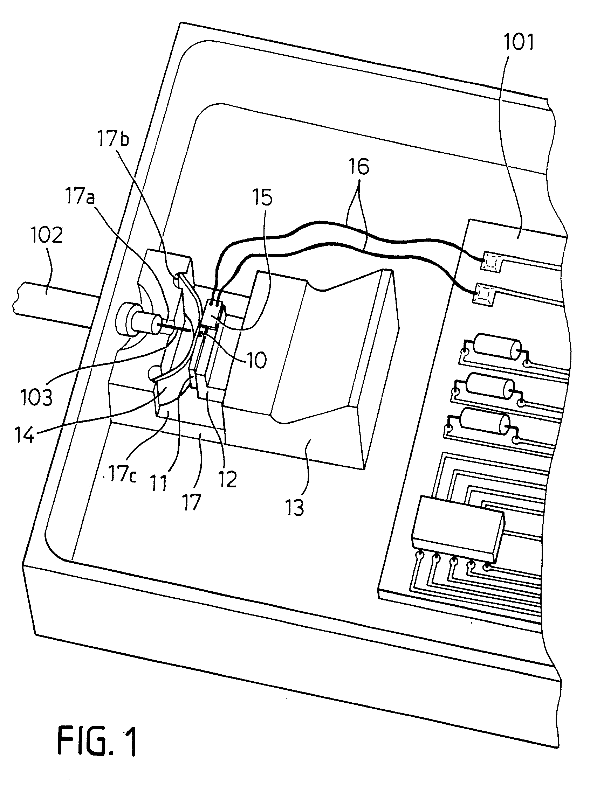

Wie die Fig. 1 zeigt, wird durch ein Gehäuse 100 mit einer Elektronikschaltung 101 ein Glasfaserkabel 102 geführt, wobei die Bohrung hierfür in einer Seitenwand in Z-Richtung bereits grob ausgerichtet ist. Nach der Hindurchführung des Kabels wird die Bohrung fest und gasdicht verschlossen und das von der Isolation freigelegte Ende der Lichtleitfaser 103 relativ genau in der Z-Richtung auf die Laserdiode 10 justiert.

Hierzu ist in dem zum Glasfaserkabel 102 gewandten Seitenteil eines Trägerelementes 17 - auf das nachfolgend noch Stellung genommen wird - eine Bohrung oder ein Schlitz l7a angebracht, worin das freie Lichtleitfaserende 103 ausgerichtet lagert. Hierdurch ist eine einseitige Einspannung der Lichtleitfaser gegeben, die Wärmedehnungen spannungslos aufnehmen kann ohne daß die Funktionsfähigkeit der Elektronik 101 beeinträchtigt wird, denn die Z-Ausrichtung auf die Laserdiode 10 ist nicht so kritisch wie die X- und Y-Ausrichtungen.

Wie die Zeichnung zeigt, ist der Chip 11 mit der Laserdiode 10 mit einer winkelförmig gestalteten Wärmesenke 12 versehen. Außerdem ist an dem Chip 11 eine sogenannter "Lötstützpunkt" 15 angeordnet an dem die Stromführungskabel bzw. Anschlußkabel 16 für die Elektronik 101 angelötet werden. Dieses zu einer Einheit zusammengefaßte Element lagert nun in einer u-förmigen Ausfräsung 17c des mit einem Kühlkörper 13 ver einigten Trägerelements 17. In dieser Ausfräsung wird nun der Laserdiodenchip 10, 11 in X- und Y-Richtung grob ausgerichtet durch ein Andruckfederblatt 14 gehalten. Dieses Federblatt wird in rund oder nutenförmig ausgefrästen Lagerstellen 17b vorgespannt eingeklemmt und drückt mit ihrer Stirnfläche den Chip 11 mit seiner Wärmesenke 12 an hintere Wand der Ausfräsung 17c.

Die Feinjustierung in X- und Y-Richtung erfolgt nun mittels einer der bekannten Verschiebegreifzangen-Einrichtungen, die den vorgespannten Chip 11 problemlos in die genauen Positionen schieben. Anschließend wird der Laserdiodenchip mit seiner Wärmesenke durch Laser-Punktschweißen in der ausgerichteten Position fixiert und gleichfalls wird so der Kühlkörper 13 mit dem Trägerelement 17 auf der Elektronik-Schaltungsplatte fixiert.

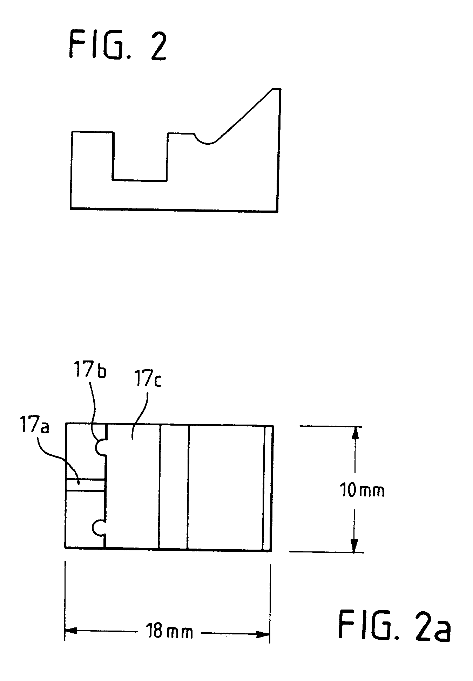

In den Figuren 2 und 2a ist ein Ausführungsbeispiel des Trägerelementes aus Kupfer gezeigt, bei dem Trägerelement 17 und Kühlkörper 13 aus einem Stück gebildet sind.

Durch die vorgeschlagene Ausführungsform ist eine Reihe von Vorteilen gegeben: Es ist eine Gehäusedurchführung für das Glasfaserkabel gegeben, die keiner genauen Justage bedarf und aufwandslos gasdicht verschlossen werden kann, es ist weiterhin eine wesentliche Vereinfachung der Justierung der Lichtleitfaser geschaffen und es ist durch den Fortfall der Z-Richtung eine problemlose Laserdiodenchip-Justierung möglich geworden, was zusammen zu einer erheblichen Reduzierung des Ausschusses und der Montagezeit führt.

## Ansprüche

1. Anordnung für eine Laserdiode mit angeschlossener Ansteuerelektronik, die in Form eines Chips mit einer Wärmesenke vor einer ortsfesten Lichtleitfaser positioniert ist, **dadurch gekennzeichnet,** daß die durch die Wand eines Elektronikgehäuse (100) geführte Lichtleitfaser (103) eines Glasfaserkabels (102) in einer Bohrung oder einem Schlitz (17a) eines Trägerelementes (17) genau in Z-Richtung justiert und gehalten lagert und der mit der Laserdiode (10) versehene Chip (11) mit einer Wärmesenke (12) versehen in einer Ausfräsung (17c) des Trägerelementes (17) mittels eines Andruckfederblattes (14) in seiner Grobausrichtung gegenüber der Spitze der Lichtleitfaser (103) gehalten und mittels einer bekannten Verschiebegreifzangen-Einrichtung in X- und Y-Richtung justiert und anschließend durch Laserpunktschweißen fixiert wird, wobei gleichzeitig das Trägerelement (17) mit der Wärmesenke (12) mit einem Kühlkörper (13) durch dieses Punktschweißen verbunden wird.

2. Anordnung nach Anspruch 1, **dadurch gekennzeichnet,** daß der Laserdiodenchip (10, 11) mit einem Lötstützpunkt (15) in Form eines Plattenelements für die Bondung der Anschlußdrähte (16) für die Elektronik (101) versehen ist.

3. Anordnung nach Anspruch 1 oder 2, **dadurch gekennzeichnet,** daß Trägerelement (17) und Kühlkörper( 13) als einteiliges Bauteil aus Kupfer gebildet sind, das eine Ausfräsung (17c) für den Laserdiodenchip (10, 11) mit Wärmesenke (12) und zwei Lagerstellen (17b) zum Einspannen des Andruckfederblattes (14) aufweist.

FIG. 1

10573

# FIG. 2

# FIG. 2a

17b
17c
17a

10 mm

18 mm

10573